Europäisches Patentamt

(19) European Patent Office

Office européen des brevets

(11) Numéro de publication: **0 283 368**
**A1**

(12) **DEMANDE DE BREVET EUROPEEN**

(21) Numéro de dépôt: **88400477.1**

(22) Date de dépôt: **01.03.88**

(51) Int. Cl.⁴: **H 03 H 9/09**

(30) Priorité: **06.03.87 FR 8703069**

(43) Date de publication de la demande:
**21.09.88 Bulletin 88/38**

(84) Etats contractants désignés:
**AT BE CH DE FR GB IT LI LU NL SE**

(71) Demandeur: **COMPAGNIE D'ELECTRONIQUE ET DE PIEZO-ELECTRICITE - C.E.P.E.**
**44, rue de la Glacière**
**F-95100 Argenteuil (FR)**

(72) Inventeur: **Aubry, Jean Pierre**
**THOMSON-CSF SCPI 19, avenue de Messine**
**F-75008 Paris (FR)**

**Fragneau, Marc**
**THOMSON-CSF SCPI 19, avenue de Messine**
**F-75008 Paris (FR)**

**Michel, Luc**
**THOMSON-CSF SCPI 19, avenue de Messine**
**F-75008 Paris (FR)**

(74) Mandataire: **Guérin, Michel et al**
**THOMSON-CSF SCPI 19, avenue de Messine**
**F-75008 Paris (FR)**

(54) **Résonateur piézo-électrique à faible sensibilité barométrique.**

(57) L'invention concerne un résonateur piézo-électrique à faible sensibilité barométrique comprenant une lame vibrante (21) en matériau piézo-électrique comprise entre deux électrodes (22) et encapsulée dans un boîtier, comprenant un capot et une embase (26) traversée de deux poteaux (27) de maintien conducteurs assurant la liaison avec les électrodes (22). La lame vibrante (21) est fixée élastiquement aux poteaux de maintien (27). Les supports de fixation élastiques sont constitués par des premiers suports élastiques (29) entre les poteaux et une lame intermédiaire (30) et par des seconds supports (31) entre la lame vibrante et la lame intermédiaire. Les seconds supports (31) sont disposés sur une ligne de non déformation de la lame intermédiaire.

Application aux résonateurs piézo-électriques, en particulier ceux utilisés en aéronautique.

FIG.4

## Description

RESONATEUR PIEZO-ELECTRIQUE A FAIBLE SENSIBILITE BAROMETRIQUE

La présente invention concerne un résonateur piézo-électrique à faible sensibilité barométrique comportant une lame vibrante en matériau piézo-électrique encapsulée dans un boîtier constitué d'une embase surmontée d'un capot.

Les résonateurs piézo-électriques sont utilisés généralement dans les oscillateurs constituant des bases de temps d'un grand nombre d'appareillages.

La qualité essentielle d'une base de temps est de délivrer une fréquence aussi stable que possible en fonction des différents paramètres qui peuvent varier dans son environnement.

Dans le matériel aéronautique tel que les avions, les satellites, etc, les oscillateurs utilisant de tels résonateurs piézo-électriques doivent être aussi peu sensibles que possible aux variations de pression entre l'intérieur et l'extérieur du boîtier enfermant la lame vibrante.

La fréquence de résonance des lames piézo-électriques est fonction de la forme, de la taille de la lame, du matériau utilisé, ainsi que des métallisations déposées sur cette lame.

D'une manière générale, la lame piézo-électrique est comprise entre deux électrodes et est fixée à l'intérieur d'un boîtier constitué d'un capot et d'une embase. Cette embase est traversée par deux poteaux de maintien conducteurs assurant la liaison électrique entre les électrodes et l'extérieur du boîtier. La lame est maintenue aux deux poteaux par des supports de fixation élastiques qui peuvent également assurer la liaison électrique avec les électrodes.

L'encapsulation de la lame vibrante peut être effectuée dans une configuration où la pression à l'intérieur du boîtier est soit inférieure, soit égale, soit supérieure à la pression extérieure. Le calage de la fréquence de résonance d'un résonateur piézo-électrique est effectué dans une de ces configurations en fonction des conditions d'utilisation futures.

Le fait de passer dans une autre configuration provoque une déformation du capot, de l'embase, des poteaux, des supports de fixation élastiques. La lame vibrante se déforme aussi. Il se produit donc une variation de la fréquence de résonance.

L'invention apporte une solution au problème ainsi posé et permet d'améliorer sensiblement le coefficient de sensibilité à la pression des résonateurs.

Le résonateur selon l'invention comporte une lame vibrante en matériau piézo-électrique comprise entre deux électrodes et encapsulée dans un boîtier constitué d'un capot et d'une embase, cette embase étant traversée par deux poteaux de maintien conducteurs assurant la liaison électrique avec lesdites électrodes, la lame vibrante étant fixée élastiquement aux poteaux et il est caractérisé en ce qu'il comprend une lame intermédiaire, en ce que la fixation élastique est constituée par au moins deux premiers supports élastiques entre les poteaux de maintien et la lame intermédiaire et par au moins deux seconds supports élastiques entre la lame vibrante et la lame intermédiaire, ces seconds supports étant disposés sur une ligne de non déformation de la lame intermédiaire. Par ligne de non déformation, on entend ici une ligne de points subissant des déplacements aussi faibles que possible sous l'action d'une déformation de l'embase et du capot en présence d'une variation de pression à l'extérieur du boîtier.

L'invention sera mieux comprise et d'autres avantages apparaîtront au moyen de la description qui va suivre donnée à titre non limitatif et des figures suivantes :

- La figure 1 représente une vue d'une lame piézo-électrique et de son embase selon l'art antérieur ;
- Les figures 2 et 3 représentent chacune une coupe verticale d'un résonateur de l'art antérieur placé dans des conditions où la pression à l'intérieur du boîtier est différente de la pression extérieure ;
- La figure 4 représente une vue d'une lame piézo-électrique et de son embase dans une disposition selon l'invention.
- Les figures 5 et 6 représentent chacune une coupe verticale d'un résonateur selon l'invention placé dans des conditions où la pression à l'intérieur du boîtier est différente de la pression extérieure.

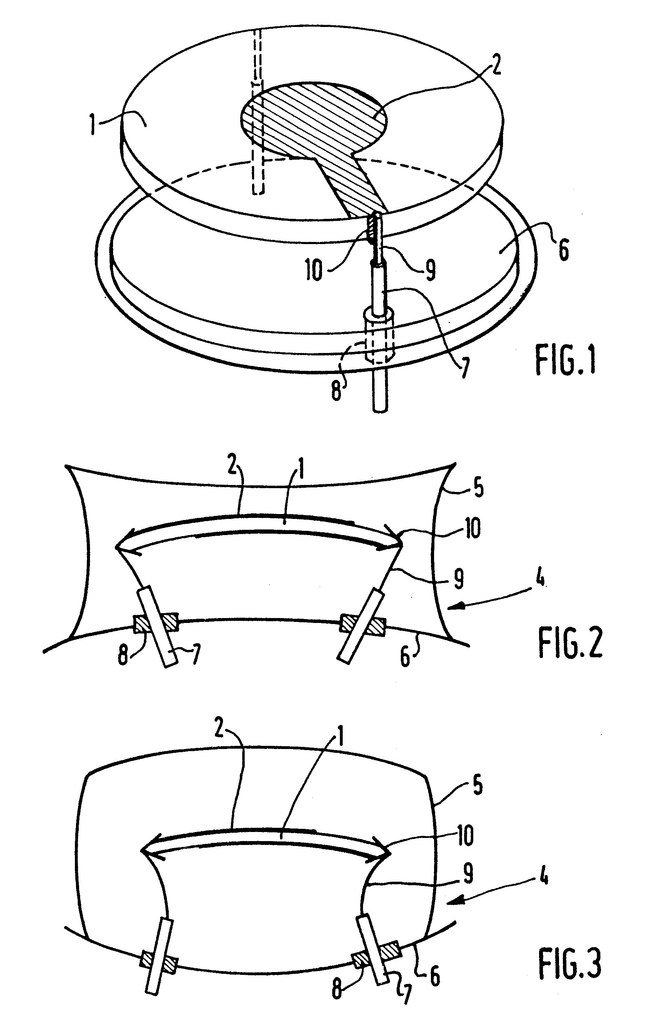

La lame piézo-électrique 1 représentée à la figure 1 est un disque et comporte une électrode métallisée 2 sur chacune de ses faces. Sur cette figure, seule l'électrode supérieure est représentée. Cette lame est encapsulée dans un boîtier constitué d'un capot non représenté pour une plus grande clarté de la figure et d'une embase 6. Cette embase 6 est traversée par deux poteaux de maintien 7 conducteurs. Au moins l'un des poteaux de maintien traverse l'embase 6 à travers une perle de verre 8 électriquement isolante. Les poteaux de maintien 7 pouvant assurer la liaison électrique avec les électrodes 2.

La lame vibrante 1 est fixée par des supports élastiques 9 aux poteaux de maintien 7. Ces supports élastiques 9 sont des ressorts métalliques. Ces supports élastiques 9 peuvent assurer aussi la liaison électrique entre les poteaux de maintien 7 conducteurs et les électrodes 2. Du ciment conducteur 10 est déposé au niveau du contact entre d'une part une extrémité du ressort 9 et d'autre part la lame vibrante 1 recouverte de l'électrode 2. L'autre extrémité du ressort 9 est soudée au poteau de maintien 7.

Si un résonateur formé d'une lame vibrante telle que décrite et encapsulée dans un boîtier se trouve dans une configuration où la pression à l'intérieur du boîtier est égale à la pression extérieure, il n'y aura pas de déformation de tous les éléments cités et la fréquence de résonance ne variera pas.

La figure 2 représente une coupe verticale d'un résonateur formé d'une lame vibrante telle que décrite à la figure 1 et encapsulée dans un boîtier 4 constitué d'une embase 6 et d'un capot 5.

Les mêmes éléments que ceux de la figure 1 portent les mêmes références. Ce résonateur est placé dans une configuration où la pression à l'intérieur du boîtier 4 est inférieure à la pression extérieure. Le boîtier se déforme entraînant un écartement des poteaux de maintien 7, une déformation des ressorts 9 et de la lame vibrante 1. La déformation a été volontairement exagérée sur cette figure pour faciliter la compréhension du problème. Cette déformation entraîne une variation de la fréquence de résonance.

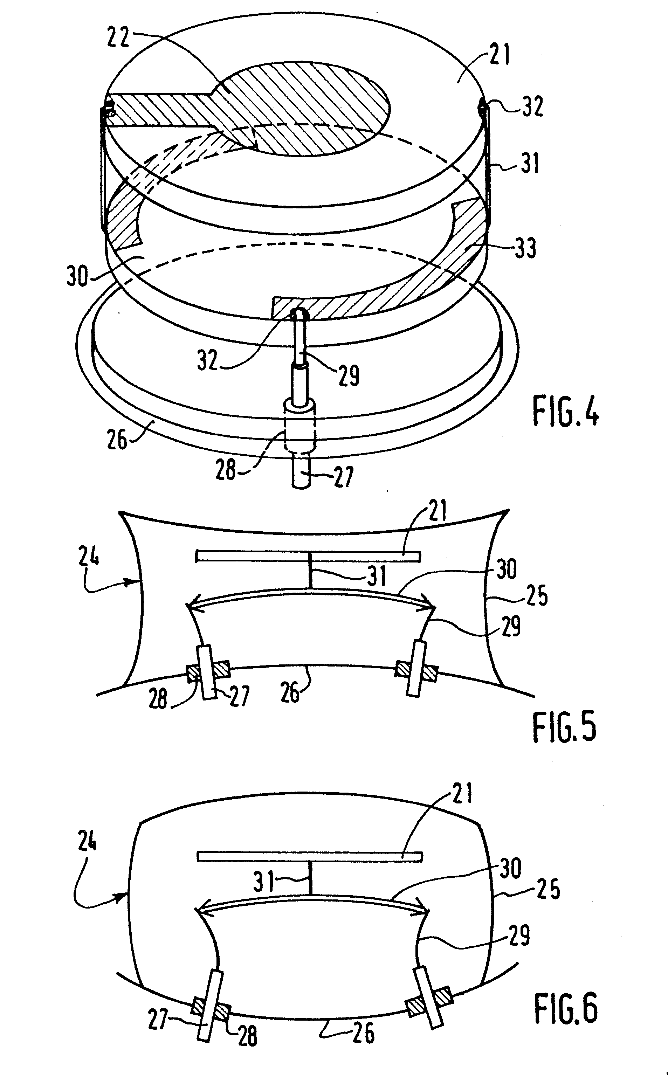

La figure 3 représente une coupe verticale du même résonateur. Les mêmes éléments que ceux de la figure 2 portent les mêmes références. Ice encore, la déformation a été volontairement exagérée. Ce résonateur se trouve dans une troisième configuration. La pression intérieure au boîtier 4 est supérieure à la pression extérieure et là encore la lame vibrante se déforme entraînant une variation de sa fréquence de résonance.

La figure 4 est un exemple de réalisation d'un résonateur selon l'invention.

La lame vibrante 21 est par exemple, un disque en quartz et comporte une électrode 22 sur chacune de ses faces. Sur cette figure, seule l'électrode supérieure est représentée. Cette lame 21 est encapsulée dans un boîtier constitué d'un capot non représenté et d'une embase 26. Cette embase 26 est traversée par deux poteaux de maintien 27 conducteurs. Au moins l'un de ces poteaux 27 traverse l'embase 26 à travers une perle de verre 28 électriquement isolante. Les poteaux de maintien 27 peuvent assurer la liaison électrique entre les électrodes 22 et l'extérieur du boîtier.

Des premiers supports élastiques 29 assurent la liaison mécanique entre les poteaux 27 et une lame intermédiaire 30. Cette lame intermédiaire 30 ayant un rôle de support mécanique n'est pas forcément en matériau piézo-électrique.

Des seconds supports élastiques 31 assurent la liaison mécanique entre la lame intermédiaire 30 et la lame vibrante 21. Le résonateur étant placé dans des conditions où la pression intérieure au boîtier est différente de la pression extérieure, cette variation de pression entraînera une déformation du boîtier, un écartement des poteaux de maintien 27, une déformation des premiers supports élastiques 29 et de la lame intermédiaire 30.

On a constaté que la déformation de la lame 30 de même d'ailleurs, que celle de la lame vibrante 1 de la figure 1, est la plus importante dans une zone périphérique autour de l'endroit où sont fixés les premiers supports élastiques 29 et on peut même constater qu'il existe une ligne de non déformation. Cette ligne de non déformation est définie par les points de la lame 30 qui ne subissent pratiquement pas de déplacement lors d'un écartement des poteaux de maintien 27 sous l'effet d'une variation de pression.

Dans le cas où la lame intermédiaire est un disque, les supports de fixation étant diamétralement opposés, la ligne de non déformation sera sur un autre diamètre faisant un angle droit avec le premier diamètre. Plus généralement, que la lame intermédiaire soit ou non en forme de disque, la ligne de non déformation sera perpendiculaire à la droite joignant les deux poteaux de maintien.

Les seconds supports élastiques 31 sont disposés sur la ligne de non déformation de la lame intermédiaire 30.

D'une manière générale, on utilisera dans le cadre de la présente invention, des ressorts métalliques comme premiers supports élastiques 29 et comme seconds supports élastiques 31. Ils seront avantageusement réalisés en nickel.

Plusieurs modes de réalisation seront alors possibles :

Par exemple, les premiers et seconds supports élastiques assurent la liaison électrique entre les poteaux de maintien 27 conducteurs et les électrodes 22 de la lame vibrante. Dans ce cas, du ciment conducteur 32 sera déposé au niveau du contact entre l'extrémité supérieure des ressorts 29 et la lame intermédiaire 30, ainsi qu'entre l'extrémité supérieure des ressorts 31 et la lame vibrante 21 recouverte de l'électrode 22. L'extrémité inférieure des ressorts 29 sera soudée aux poteaux. L'extrémité inférieure des ressorts 31 sera fixée, par exemple par soudure, à la périphérie de la lame intermédiaire 30.

La liaison électrique entre les premiers supports élastiques conducteurs 29 et les seconds supports élastiques conducteurs 31 sera réalisée sous la forme d'une piste conductrice 33 à la périphérie de la lame intermédiaire.

Dans un autre mode de réalisation on utilise de petits fils conducteurs soudés entre les poteaux de maintien conducteurs et les électrodes de la lame vibrante.

Une troisième solution consiste à réaliser une combinaison des deux moyens précédents : ressorts conducteurs entre les poteaux et la lame intermédiaire et fils conducteurs entre la lame intermédiaire et la lame vibrante ou vice-versa.

Les figures 5 et 6 représentent des coupes verticales de résonateurs formés d'une lame vibrante et d'une lame intermédiaire telles que décrites à la figure 4. Ces lames sont encapsulées dans des boîtiers 24 constitués d'un capot 25 et de l'embase 26. Les mêmes éléments que ceux de la figure 4 portent les mêmes références. Ces résonateurs sont placés dans des configurations où la pression à l'intérieur du boîtier 24 est différente de la pression à l'extérieur.

Sur la figure 5, la pression à l'intérieur du boîtier est inférieure à la pression à l'extérieur du boîtier. L'embase 26 se déforme en provoquant un écartement des poteaux 27. La déformation représentée sur cette figure est volontairement exagérée. L'écartement des poteaux entraîne une déformation de la lame intermédiaire 30. Les seconds supports de fixation 31, placés sur une ligne de non déformation de la lame intermédiaire 30 ne bougent pas, la lame vibrante 21 non plus. Il n'y a pas de variation de la fréquence de résonance.

Sur la figure 6, la pression à l'intérieur du boîtier est supérieure à la pression à l'extérieur du boîtier. Pour les mêmes raisons que précédemment, la lame vibrante 21 ne se déforme pas. Il n'y a pas de variation de la fréquence de résonance.

Les résultats sont d'autant meilleurs si le coefficient de dilatation de la lame intermédiaire 30 est voisin de celui de la lame vibrante 21.

Les résultats sont encore meilleurs si les deux lames sont en même matériau par exemple en quartz.

Les exemples de réalisation suivants montrent la diminution de la sensibilité barométrique d'un résonateur selon l'invention par rapport à un résonateur classique.

Le coefficient de sensibilité à la pression $k_p$ d'un résonateur piézo-électrique est donné par la relation

$\Delta f/f = k_p \times P$

où $\Delta f/f$ est la variation relative de la fréquence de résonance et

P la différence entre la pression intérieure et la pression extérieure au boîtier

. pour un quartz auto suspendu à 10 MHz coupe SC - mode de vibration partiel 3 avec lame intermédiaire

$k_p \simeq 3.10^{-15} / Pa$

. pour un quartz auto suspendu à 10 MHz coupe SC - mode de vibration partiel 3 sans lame intermédiaire

$k_p \simeq 30.10^{-15} / Pa$

L'invention peut s'appliquer à tous les types de résonateurs : en quartz, tantalate, berlinite, montés en boîtier métallique.

La lame vibrante peut être soit monolithique, soit découpée, soit érodée. Il peut y avoir plus de deux électrodes et celles-ci peuvent être adhérentes ou non à la lame vibrante.

## Revendications

1. Résonateur à faible sensibilité barométrique comportant une lame vibrante (21) en matériau piézo-eléctrique comprise entre deux électrodes (22) et encapsulée dans un boîtier constitué d'un capot et d'une embase (26), cette embase étant traversée par deux poteaux de maintien (27) conducteurs assurant la liaison électrique avec les dites électrodes (22), la lame vibrante (21) étant fixée élastiquement aux poteaux (27), caractérisé en ce que le résonateur comprend une lame intermédiaire (30), que la fixation élastique est constituée par au moins deux premiers supports élastiques (29) entre les poteaux (27) et la lame intermédiaire (30) et par au moins deux seconds supports élastiques (31) entre la lame intermédiaire (30) et la lame vibrante (21), ces seconds supports de fixation (31) étant disposés sur une ligne de non déformation de la lame intermédiaire (21).

2. Résonateur à faible sensibilité barométrique selon la revendication 1, caractérisé en ce que le coefficient de dilatation de la lame intermédiaire (21) est voisin du coefficient de dilatation de la lame vibrante (30).

Résonateur à faible sensibilité barométrique selon la revendication 1, caractérisé en ce que la lame intermédiaire (30) est réalisée en même matériau que la lame vibrante (21).

4. Résonateur à faible sensibilité barométrique selon les revendications 1 à 3, caractérisé en ce que les supports de fixation élastiques (29, 31) des lames (21, 30) sont conducteurs de l'électricité.

5. Résonateur à faible sensibilité barométrique selon les revendications 1 à 4, caractérisé en ce que des fils conducteurs assurent la liaison électrique entre les poteaux de maintien (27) et les électrodes (22) de la lame vibrante (21).

6. Résonateur à faible sensibilité barométrique selon les revendications 1 à 5, caractérisé en ce que la liaison électrique entre les premiers supports de fixation élastique (29) et les seconds supports (31) est réalisée par une piste conductrice (33) sur la lame intermédiaire (30).

0283368

FIG.1

FIG.2

FIG.3

0283368

FIG.4

FIG.5

FIG.6

Office européen
des brevets

# RAPPORT DE RECHERCHE EUROPEENNE

Numéro de la demande

EP 88 40 0477

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | DE-A-2 534 683 (CENTRE ELECTRONIQUE HORLOGER) <br> * En entier * <br> --- | 1,4-6 | H 03 H 9/09 |
| A | DE-A-1 939 020 (LICENTIA) <br> * En entier * <br> --- | 1 | |
| A | US-A-4 292 562 (A. FEDER) <br> * En entier * <br> --- | 1 | |
| A | US-A-3 339 091 (D.L. HAMMOND et al.) <br> * Figure 1; colonne 1, lignes 53-63 * <br> ----- | 2,3 | |

DOMAINES TECHNIQUES
RECHERCHES (Int. Cl.4)

H 03 H

Le présent rapport a été établi pour toutes les revendications

| Lieu de la recherche | Date d'achèvement de la recherche | Examinateur |
|---|---|---|
| LA HAYE | 15-06-1988 | COPPIETERS C. |